# EUROPEAN PATENT APPLICATION

(11) **EP 1 065 786 A2**
(43) Date of publication of application: **03.01.2001**
(21) Application number: 00113578.9
(22) Date of filing: 27.06.2000
(51) Int. Cl.: H03G 3/30

(54) **Communication set radio communication system and automatic gain control method for radio communication set**

(30) Priority: 30.06.1999 JP 18454799
(71) Applicant: NEC CORPORATION, Tokyo (JP)
(72) Inventor: Tomiyori, Yutaka, Minato-ku, Tokyo (JP)
(74) Representative: Baronetzky, Klaus, Dipl.-Ing.

(57) **Abstract**

An AGC circuit is formed such that it appropriately controls the amplification factor of a gain control amplifier 7 on the basis of in-reception electric field intensity. Both time and cycle of in-reception electric field intensity measurement and cycle of control of in-reception electric field intensity measurement by feeding back the measurement time and cycle data are changed.

## Description

### BACKGROUND OF THE INVENTION

The present invention relates to radio communication sets, radio communication systems and automatic gain control methods for radio communication sets.

Conventional mobile radio transmitting/receiving sets such as portable telephone sets adopt AGC (automatic gain control), i.e., a method of automatically controlling the amplification factor (i.e., gain) in a received signal amplifier on the basis of changes in in-reception electric field intensity. In the AGC, it is necessary to avoid that the amplitude of a desired received signal or the like erroneously follows up level variations provided by the demodulation or changes due to the effects of multi-pass fading. Accordingly, in the prior art AGC usually average in-reception power level in an appropriate time is calculated for executing the gain control on the basis of the calculated power level.

This is so because a sufficiently long time interval of control is provided with respect to the demodulation rate on the basis of the average in-reception power level, data signal contained in the amplitude component may not be correctly received depending on the demodulating system. Also, unless sufficient robustness provided with respect to fading variations, stable receiving performance can not be obtained.

The prior art AGC can be directly applied without any problem to well-known TDMA system, because in this system the channel is used on a time division basis to avoid interference with other channels. On the other hand, CDMA system has a character that it allows interference with other channels. Therefore, virtual noise results from signals transmitted on the other channels. Besides, virtual noise variations result from other channel signal level variations. That is, the CDMA system has a character that noise is always present and varied, and therefore the prior art AGC can not be directly applied to this system.

Some conventional systems for receiving a plurality of different radio channel data have a function of monitoring in-reception levels of the other channels than the channel, on which data is being received. This function is provided for the purpose of retrieving for a better available communication channel than the channel in use in communication at an appropriate frequency and switching the prevailing channel over to a better channel, if any, thus always maintaining the best communication state.

In this case, a receiving set having only a single receiving circuit system has to monitor the other channels by tentatively interrupting the communication on the communication channel in use. The monitoring time is thus desired to be as short as possible. The longer the monitoring time, the longer is the time of interruption of the communication on the prevailing communication channel, and the communication efficiency is degraded.

It is conceivable to provide two receiving circuit systems so as to be able to monitor the other channels without interrupting the communication on the prevailing communication channel. In many cases, however, it is undesired to adopt this construction from the standpoints of reducing the size, the weight, the price and the current consumption of the receiving set.

As discussed above, appropriate automatic control of the gain in the receiving unit and communication channel monitoring without excessively deteriorating the communication efficiency of certain communication are opposite functions to each other.

### SUMMARY OF THE INVENTION

The present invention was made in order to overcome the drawbacks described above in the prior art, and it has an object of providing a radio communication set, a radio communication system and an automatic gain control method for a radio communication set, which can prevent excessive communication efficiency deterioration by appropriately executing communication channel monitoring and automatic gain control in receiving unit.

According to an aspect of the present invention, there is provided a radio communication set comprising measuring means for measuring in-reception electric field, intensity of signals transmitted from base stations of a first and a second telephone system different in communication system from each other, data transmission and reception being made between the radio communication set and the base station of either the first or second telephone system selected on the basis of the result of measurement in the measuring means.

The first telephone system is based on CDMA system, and the second telephone system is based on a system different from the CDMA system. The telephone system different from the CDMA system is based on TDMA system.

According to another aspect of the present invention, there is provided a radio communication set comprising receiving means for receiving radio signal, measuring means for measuring in-reception electric field intensity in a predetermined measuring time, and automatic gain control means for controlling the amplification factor of the receiving means on the basis of the in-reception electric field intensity measured in the measuring means.

The radio communication set further comprises switching means for switching the communication channel in use on the basis of the in-reception electric field intensity measured in the measuring means, the measuring time being set on the basis of the communication channel selected by switching in the switching means. The in-reception electric field intensity measured in the measuring means is an average of a plurality of in-reception electric field intensity values obtained in the measuring time. At least one of a plurality of radio communication systems is selected on the basis of the in-reception electric field intensity measured in the measuring means. The measuring time is set on the basis of the selected one of the plurality of radio communication systems. The r predetermined number is set on the basis of the selected one of the plurality of radio communication systems.

According to other aspect of the present invention, there is provided a radio communication set comprising receiving means for receiving radio signal, measuring means for measuring in-reception electric field intensity in a predetermined measuring time, selecting means for selecting a radio communication system to be used on the basis of the in-reception electric field intensity measured in the measuring means, setting means for setting the measuring time on the basis of the radio communication system selected in the selecting means, and automatic gain control means for controlling the amplification factor in the receiving means on the basis of the in-reception electric field intensity measured in the measuring time set in the setting means.

The measuring means measures the in-reception electric field intensities of signals transmitted from base stations in a first and a second telephone system different in communication system from each other. The measuring means measures the in-reception electric field intensity of the signal transmitted from the base station in the second telephone system by interrupting the data transmission and reception to and from the base station in the first telephone system for a predetermined time. The measuring means measures the in-reception electric field intensity of the signal transmitted from the base station of the second telephone system when the line quality provided by the first telephone system is deteriorated. The measuring means measures the in-reception electric field intensity of the signal transmitted from the base station of the second telephone system at a predetermined frequency. The automatic gain control means controls the amplification on the basis of the switching of communication channels. The radio communication set further comprises oscillating means with the oscillation frequency thereof controlled on the basis of the a phase difference with respect to a reference signal, phase comparing means for obtaining the phase difference between a signal obtained by frequency dividing the output of the oscillating means with a predetermined frequency division ratio and the reference signal, and frequency division ratio control means for controlling the frequency division ratio on the basis of the result of measurement in the measuring means, and the automatic gain control means controls the amplification factor on the basis of the frequency division ratio. The frequency division ratio control means includes means for calculating the average of the result of measurement in the predetermined time, and frequency division setting means for setting the frequency division ratio on the basis of the calculated average and a predetermined desired value. The desired value is determined on the basis of the slot length.

According to still other aspect of the present invention, there is provided a radio communication set comprising receiving means for receiving radio signal, and automatic gain control means for controlling the amplification factor in the receiving means on the basis of in-reception electric field intensity of the received signal in a predetermined time, the automatic gain control means including computing means for determining the in-reception electric field intensity by computing the two orthogonal components of the received signal, a first memory for successively storing computed in-reception electric field intensities, calculating means for calculating an average of in-reception electric field intensity data read out from the first memory in every predetermined time, a second memory for storing at least the newest and the immediately preceding values of average calculated in the calculating means, and gain control means for controlling the amplification factor on the basis of the result of comparison of calculated values stored in the second memory.

The second memory stores average values calculated in the calculating means as history, and the gain control means controls the amplification factor on the basis of the average value corresponding to a communication channel used before among the average values stored as history in the second memory. The radio communication set further comprises control means for detecting the communication channel on the basis of a frequency division ratio preset in a frequency divider in the receiving means and reading out the average value corresponding to the detected communication channel from the second memory.

According to further aspect of the present invention, there is provided a radio communication system comprising a radio communication set on the basis of one of the above sets, and a base station for transmitting and receiving data to and from the radio communication set, wherein the radio communication set includes means for notifying the measuring time of measurement in the measuring means to the base station, the base station holding a fixed communication level in the measuring time.

According to still further aspect of the present invention, there is provided an automatic gain control method for a radio communication set comprising a receiving step of receiving radio signal, a measuring step of measuring in-reception electric field intensity in a predetermined measuring time, a selecting step of selecting a radio communication channel to be used on the basis of the in-reception electric field intensity measured in a predetermined measuring time, a setting step of setting the measuring time on the basis of the radio communication step selected in the selecting step, and an automatic gain control step of controlling the amplification factor in the receiving step on the basis of the in-reception electric field intensity measured in the measuring time set in the setting step.

In the measuring step in-reception electric field intensities of signal transmitted from base stations in a first and a second telephone system different in communication system from each other are measured. In the measuring step the in-reception electric field intensity of the signal transmitted from the base station in the second telephone system is measured by interrupting data transmission and reception to and from the base station in the first telephone system for a predetermined time. In the measuring step the in-reception electric field intensity of the signal transmitted from the base station of the second telephone system is measured when the line quality provided by the first telephone system is deteriorated. In the measuring step the in-reception electric field intensity of the signal transmitted from the base station in the second telephone system is measured at a predetermined frequency. In the automatic gain control step the amplification is controlled in response to communication channel switching.

According to other aspect of the present invention, there is provided an automatic gain control method for a radio communication set, which comprises receiving means for receiving radio signal, and automatic gain control means for controlling the amplification factor in the receiving means on the basis of the in-reception electric field intensity of the received signal in a predetermined time, the method comprising a step of determining the in-reception electric field intensity by computing two orthogonal components of the received signal, a step of successively storing computed in-reception electric field intensities in a first memory, a step of calculating the average of stored in-reception electric field intensities read out very predetermined time, a step of storing the newest and the immediately preceding calculated average values, and a step of controlling the amplification factor on the basis of the result of comparison of stored average values.

The calculated average values are stored as history in the second memory, and the amplification factor is controlled on the basis of the average corresponding to a communication channel used before among the average values stored as history. The automatic gain control method further comprises a step of detecting the communication channel on the basis of a frequency division ratio preset in a frequency divider in the receiving means and reading out the average value corresponding to the detected communication channel from the second memory, the amplification being controlled on the basis of the read-out average value.

In summary, in a receiver according to the present invention, AGC for automatically and adequately controlling the amplification factor of receiving unit on the basis of in-reception electric field intensity, provides a function of permitting changing AGC parameters, such as the time and cycle of in-reception electric field intensity measurement and also cycle of amplification factor control with feed-back of detected measurement time and cycle.

As means for detecting the necessity of the AGC parameter switching, the AGC has a function of permitting the switching only when necessary. The AGC has a further function of permitting the setting of required AGC accuracy after the switching has been executed. The AGC parameter switching is thus allowed in dependence on necessity in such cases as when it is necessary to maintain as good communication state as possible or when it is necessary to determine only rough in-reception electric field intensity level.

As means for detecting the necessity of the AGC parameter switching, the AGC further has a function of automatically detecting switching of communication channels and the frequency of the new communication channel and also a function of changing the time of control on the basis of the result of detection. Still further, the AGC has a function of storing AGC parameters concerning the communication channel in use. When the detected new frequency is a communication channel used before, the AGC provides a function of using preliminarily stored AGC parameter values used as initial values.

As a further function, when the new communication channel has once been used before, the lapse of time since the time of the past use is detected, and when the communication channel is to be used a gain within a predetermined period of time since the time of the previous use, past AGC parameter values that have been stored are used as initial values. When the predetermined period of time has already been elapsed, optimum AGC parameter values are detected again.

Alternatively, instead of or in addition to the time lapse detection, system parameters concerning the new communication channel are preliminarily obtained, and AGC parameter initial values corresponding to the quality and status of the communication channel are used.

When channel switching is executed over to a communication channel under different communicating conditions, the above functions permit optimizing the initial value of the amplification factor of the received signal amplifier and the capacity of detecting and supplementing the receiving conditions in a necessary in a minimum necessary time and in a sufficient status.

Other objects and features will be clarified from the following description with reference to attached drawings.

### BRIEF DESCRIPTION OF THE DRAWINGS

Fig. 1 is a block diagram showing one embodiment of the radio communication set according to the present invention;
Fig. 2 is a drawing representing a base station of GSM system and another base station of CDMA system;
Fig. 3 is a drawing representing the in-reception electric field intensity with lapse of time;
Fig. 4 is a block diagram PLL including the frequency synthesizer IC 23 in Fig. 1;
Fig. 5 is a block diagram PLL including the frequency synthesizer IC 24 in Fig. 1;
Fig. 6 is an exemplified structure of the memory 32 in Fig. 1;
Fig. 7 is an exemplified structure of the memory 32 by using registers;
Fig. 8 is an exemplified structure of the memory 37 in Fig. 1;
Fig. 9 is an example of the table in the gain controller switching controller 36 in Fig.1;
Fig. 10 is another example of the table in the gain controller switching controller 36 in Fig.1;
Fig. 11 is an exemplified structure of radio communication set without the frequency synthesizer 26;
Fig. 12 is a flow chart of the automatic gain control method in the radio communication set;
Fig. 13 is a flow chart of the automatic gain control method in the AGC unit in Fig. 1; and
Fig. 14 shows a situation of data communication between a base station and a radio communication set.

### PREFERRED EMBODIMENTS OF THE INVENTION

Preferred embodiments of the present invention will now be described with reference to the drawings.

Now, a case when the radio communication set utilizes a plurality of different communication channels is considered. As different communication channel may be considered those different in only the carrier frequency, in the received wave quality, for instance, in the case of differences of the position of the transmitting station side and propagation environment up to the radio communication set, or in the cases of communication with other transmitting stations having different signal formats or of different modulating systems. Where it is able to communicate with other transmitting stations of different modulating systems, the following merit can be obtained. Even in a district where no transmitting station of a certain modulating system is installed, an installed transmitting station, if any, of a different modulating system can be utilized for communication. In the following example, it is assumed that the signal format and the modulating system of a communication channel to be utilized are recognized from the carrier frequency thereof.

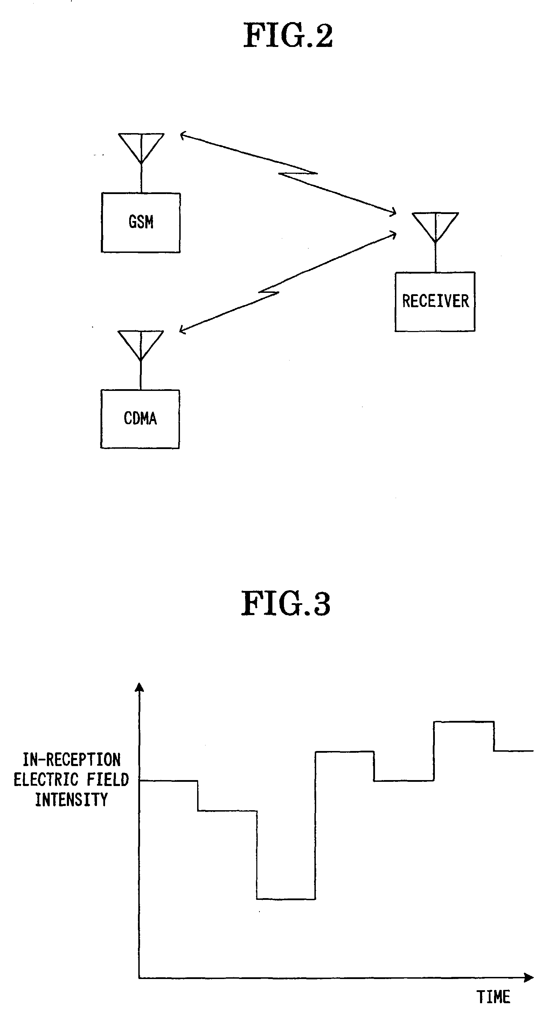

A case as shown in Fig. 2 will now be considered, in which a base station of well-known GSM (global system mobile) system and another base station of well-known CDMA (code division multiple access) system are provided for data transmission and reception to and from one receiver (i.e., mobile set). The GSM system adopts TDMA (time division multiple access), that is, it uses channel on a time division basis, for preventing radio interference with other channels. On the other hand, the CDMA system restores transmitted data by using highest correlation value codes, and naturally allows radio interference with other channels. The CDMA system is further different from the GSM system in that in this system the transmission power level is changed in a short cycle with changes in the distance from base station or the like, although a constant transmission power level is held in each slot.

Therefore, the AGC circuit in the GSM system cannot be directly applied to the CDMA system. This will further be described with reference to Fig. 3. In the CDMA system, the in-reception electric field intensity is changed step-wise slot by slot with lapse of time, but the transmission power is held constant in one slot. The in-reception electric field intensity is thus changed step-wise slot by slot with time lapse.

With step-wise transmission power level changes the level of transmitted and received signals to and from other receivers is changed. This gives rise to virtual noise changes. Although in the Figure the in-reception electric field intensity is not shown to be changed in each slot, actually it is changed slightly due to fading.

In the CDMA system, therefore, it is necessary to hold only slight changes in the in-reception electric field intensity constant with the AGC circuit. If the AGC circuit in the GSM system is directly applied to the CDMA system to this end, if functions to hold a constant level by suppressing not only the slight changes but also the overall changes inclusive of the step-wise change part of the in-reception electric field intensity. Such operation of the AGC circuit goes counter to the purpose of the CDMA system. For this reason, the AGC circuit in the GSM system can not be applied to the CDMA system.

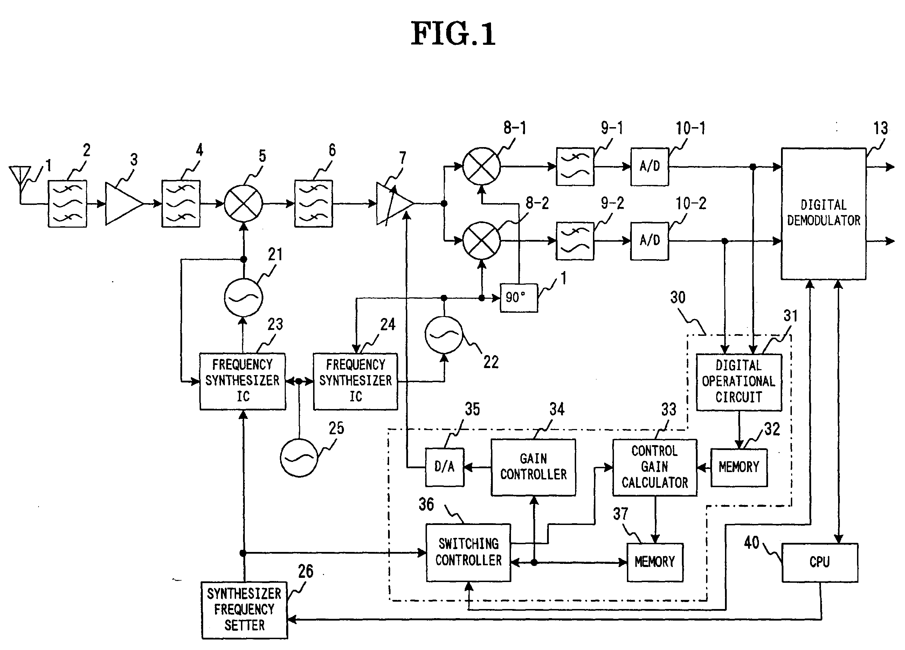

To suppress the slight changes in the in-reception electric field intensity while leaving the step-wise change part thereof as such, it is necessary to operate the AGC circuit by appropriately changing an average time calculation period to be described later on the basis of the communication channel, on which to receive data. A radio communication set including such an AGC circuit will now be described with reference to Fig. 1. In the figures to be referred to hereinafter, like parts are designated by like reference numerals.

Fig. 1 is a block diagram showing one embodiment of the radio communication set according to the present invention. Referring to the Figure, a band-pass filter 2 selectively passes only a predetermined band of wave received by an antenna 1. An LNA (low noise amplifier) 2 amplifies the output of the band-pass filter 2. An inter-stage filter 4 removes unnecessary harmonics in the amplified in-reception wave output of the LNA 3. A mixer 5 converts the output of the inter-stage filter 4 to an intermediate frequency signal by using a first local frequency fed out from a frequency synthesizer. Another inter-stage filter 6 removes unnecessary harmonics and also image wave, etc. from the output of the mixer 5. A gain control amplifier 7 amplifies the output of the inter-stage filter 6, and feeds its output to orthogonal demodulators 8-1 and 8-2.

The orthogonal amplifiers 8-1 and 8-2 multiply the received signal output of the gain control amplifier 7 by respective local frequencies, one being a first local frequency identical with the intermediate frequency and the other being a second local frequency obtained from a 90-degree phase shifter 11, which phase shifts the first local frequency by 90 degrees. Thus, two orthogonal base-band components of received signal are extracted.

Low-pass filters 9-1 and 9-1 remove harmonics and shape waveform of the two extracted orthogonal components of received signal, respectively. A/D converters 10-1 and 10-2 convert the outputs of the low-pass filters 9-1 and 9-2 to sampled and quantized digital modulation components. A digital demodulator 13 executes a digital demodulating process on the digital modulation component outputs of the low-pass filters 9-1 and 9-2 to reproduce data, voice, etc.

The first and second local frequencies are generated by PLLs, which are constituted by VCOs (voltage-controlled oscillators) 21 and 22, and frequency synthesizer ICs 23 and 24, respectively, together with a TCXO (temperature-controlled crystal oscillator) 20 as reference frequency oscillator.

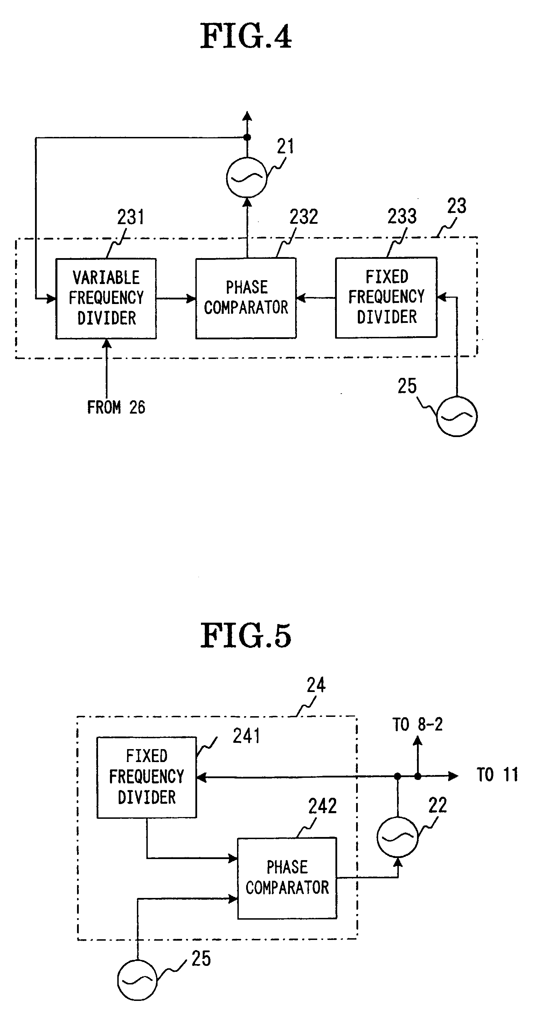

As shown in Fig. 4, the frequency synthesizer IC 23 includes a variable frequency divider 231 for frequency dividing the output of the VCO 21, a fixed frequency divider 233 for frequency dividing the output of the TCXO 25, and a phase comparator 232 for phase comparing the two frequency divider outputs. The oscillation frequency of the VCO 21 is controlled on the basis of the phase comparison result. This PLL is a stable frequency source, which feeds out the output to the mixer 5.

As shown in Fig. 5, the frequency synthesizer IC 24 includes a fixed frequency divider 241 for frequency dividing the output of the VCO 22, and a phase comparator 242 for phase comparing the outputs of the fixed frequency divider 241 and the TCXO 25. The oscillation frequency of the VCO 22 is controlled on the basis of the phase comparison result. This PLL is again a stable frequency source, which feeds out the output to the orthogonal demodulator 8-1 and also via the phase shifter 11 to the orthogonal demodulator 8-1.

Referring back to Fig. 1, the gain control amplifier 7 has its amplification factor controlled on the basis of a control voltage signal. Specifically, the amplifier 7 functions such that its amplification factor is controlled on the basis of the in-reception electric field intensity (or amplitude) such the level of inputs to the succeeding stage A/D converters 10-1 and 10-2 is always in an adequate range.

An AGC unit 30 generates a control signal fed out to the gain control amplifier 7 on the basis of the outputs of the A/D converters 10-1 and 10-2, i.e., the two orthogonal digital modulation components of received signal. The unit 30 includes a digital operational circuit 31, a memory 32, a control gain calculator 33, a gain controller 34, a D/A converter 35, a gain controller switching controller 36 and a memory 37.

The digital operational circuit 31 has an adder and a multiplier, and it obtains the arithmetic or geometric mean of the two orthogonal digital modulation component outputs of the A/D converters 10-1 and 10-2. The circuit 31 feeds out the mean thus obtained to the memory 32. Thus, instantaneous reception amplitude can be obtained.

The memory 32 successively accumulates instantaneous amplitude data inputted from the digital operational circuit 31. The control gain calculator 33 derives the variation history of the reception amplitude data accumulated in the memory 32 at a certain time interval, and obtains the average in each such interval.

Assuming that the A/D converters 10-1 and 10-2 each have eight bits and execute over-sampling at 16.364 MHz, i.e., four times the chip rate of 4.096 MHz, 8-bit data in a range of "00h" (h indicating hexadecimal number, the indication being the same hereinafter) to "FFh" are inputted to the demodulator 13 and the operational circuit 41 at a rate of 16.384 HMz. The data provided each time from the A/D converters 10-1 and 10-2 are proportional to the in-reception electric field intensity, and are "00h" when no received signal input prevails and "FFh" when the received signal input level is so high as to lead to saturation of the A/D converters (i.e., higher than the maximum level permitting A/D conversion).

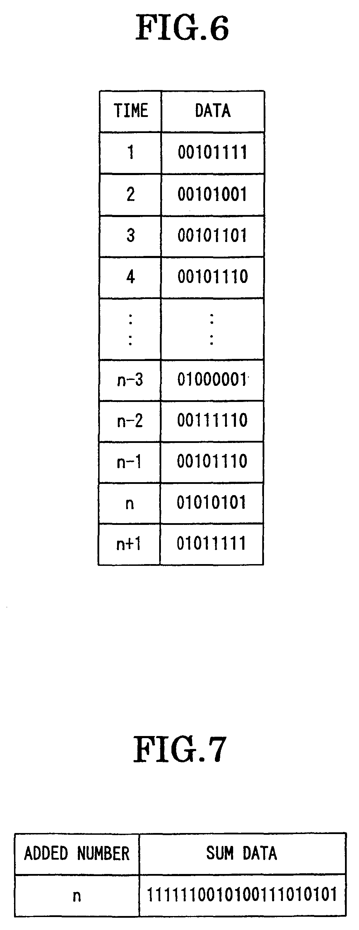

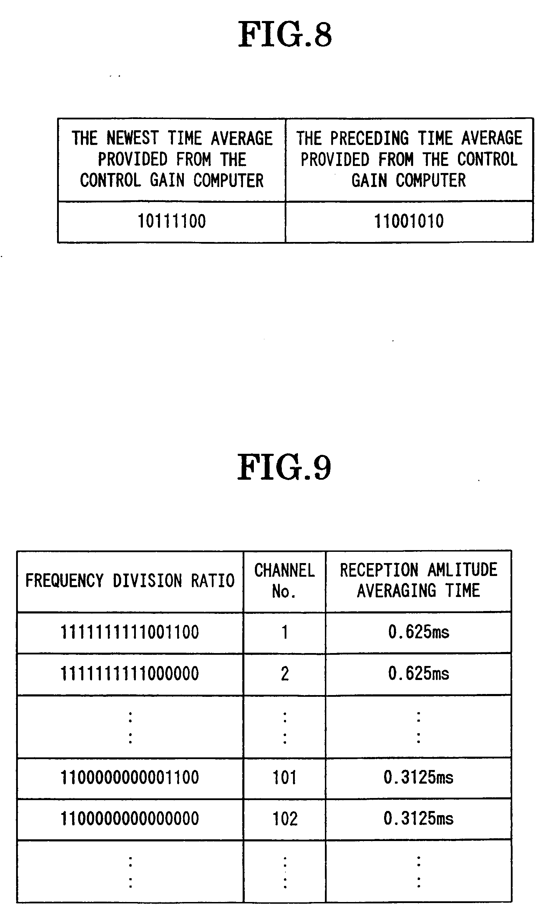

Whenever the computational circuit 31 receives 8-bit data from each of the two A/D converters 10-1 and 10-2, it executes time average computation. For example, when data "0Fh" is inputted from each of the two A/D converters, the average is "0Fh". As shown in Fig. 6, 8-bit data in a range of "00h" to "FFh" are stored in the memory 6.

The time average computation will now be described. As described above, when the sampling frequency is 16.384 MHz, the data in the memory 32 represents reception level in each cycle of 1/16.384 sec. Thus, by adding together values n times from the memory 32 and dividing the sum by n, the average in-reception in-reception electric field in a period of n × 16.384 µsec. is obtained. When executing this operation in the radio slot cycle of 0.625 msec., data corresponding in number to (0.625 msec.)/(1/16.384 µsec.) = 10,240, taken out from the memory 32, are added together, and the sum is divided by 10,240. In this way, "average in-reception electric field, intensity in a period of 0.625 msec." can be obtained. The time interval of the time averaging is varied by varying the number n.

The memory 32 can also be obtained by using a register for adding together n 8-bit data. In this case, the memory 32 is constituted by only a register of, for instance ten and several bits and a register for storing the number n of data samples added together.

For adding together, for instance, 10,240 (213 214) 8-bit data, a data addition register having twenty two bits at the most is necessary. Such a register is incremented by one as number of data samples added together whenever a data sample is inputted. Such a register is shown in Fig. 7. Denoting the number of data samples when data is read out from the register at a certain instant by x and the sum data by y, the average reception level in the sampling cycle multiplied by x sec. can be obtained by calculating y/x.

In either case, the control gain calculator 33 provides the obtained time average reception level (i.e., 8-bit data here).

The gain controller 34 appropriately corrects the control gain by comparing the newest time average and the immediately preceding time average provided by the control gain calculator 33, and feeds the corrected control gain as control voltage signal via the D/A converter 35 back to the gain control amplifier 7. The newest and immediately preceding time averages that are referred to by the gain controller 34 are stored in the memory 37.

Fig. 8 shows the two data that are stored in the memory 37. That is, the newest and the preceding time averages provided form the control gain computer 33 are stored in the memory 37. The two time averages are both 8-bit data. The gain controller 34 reads out these data stored in the memory 37. The gain control switching controller 36 provides addresses when reading out the data.

The gain controller 34 can detect a change in the reception level in the time averaging period of time for obtaining the time average by comparing the two data stored in the memory 37. By detecting this change, the gain controller 34 changes its output fed out to the D/A converter 35 in a direction of canceling the change. In this case, data about how much the output to the D/A converter 35 is to be changed in what coarseness with respect to the reception level change, is held in a table or the like. It is also possible to change the follow-up sensitivity of the AGC by changing the coarseness.

In the memory 37, the various different kinds of data described above are stored in separate areas. It is possible to use exclusive memories for the different kinds of data. However, preparation of the separate memories are physically undesired from the standpoint of reducing the size of the set casing. Physically, dividing one memory into blocks for the individual kinds of data to be stored therein has an effect of assisting the set casing size reduction.

The cycle in which the control gain computer 33 takes out the change history of the reception amplitudes accumulated in their memory 32, corresponds to the time length of averaging of the received signal. The shorter the cycle, the AGC response is quicker. If the cycle is excessively short, however, short-time level changes such as fading may be sensitively responded to result in failure of correct demodulation. Particularly, where such a modulating system that a modulating signal component may be contained in the amplitude is used, the modulating signal data may be distorted.

Conversely, if the averaging time period is excessively long, although the robustness to fading or like instantaneous changes can be ensured, graduate reception level changes accompanying the movement of the mobile transmitter/receiver set can not be followed up. In such a case, the signals inputted to the A/D converters 10-1 and 10-2 may become excessively high or be saturated, or they may become excessively low. In such case, quantization noise may be increased such that it can no longer ignored relative to the received signal, thus resulting in signal quality deterioration. To prevent such received signal quality deterioration, the control gain computer 33 should always compute the time average in an appropriate cycle.

Referring back again to Fig. 1, the construction of this mobile transmitter/receiver set will be described in greater details. A CPU 40 feeds out frequency setting data to a synthesizer frequency setter 26. The frequency setting data is a digital signal containing the output frequency value and frequency division ratio.

The synthesizer frequency setter 26 specifically is a register for presetting and holding the frequency setting data. The frequency division ratio of the frequency setting data present in the setter 26 is inputted to the frequency synthesizer IC 22. The setter 26 thus determines the output frequency of the VCO 21. In this embodiment, the signal format and the demodulating system of the communication channel for receiving data thereon are recognized from the carrier frequency on the communication channel in use.

The gain controller switching controller 36 monitors the frequency division ratio of the frequency setting data fed out from the synthesizer frequency setter 26 to the frequency synthesizer IC 23. From this frequency division ratio, the controller 36 can detect the frequency and channel No. of the communication channel in use.

The gain controller switching controller 36 has a memory table, in which adequate gain switching control parameters are stored for individual carrier frequencies capable of being used. This table will now be described with reference to Fig. 9. As shown in the Figure, appropriate values frequency division ratio, channel No. reception amplitude averaging time are provided in the table. When the frequency division ratio and the channel No. are determined, the appropriate value of the reception amplitude averaging time is determined. The appropriate value of the reception amplitude averaging time varies in dependence on whether CDMA system or GSM system is employed.

The frequency division ratio is data which is preset in the frequency synthesizer IC 23 and is citing of binary data of values dependent on the specifications of the synthesizer. For example, assuming that the CDMA and GSM systems have channel Nos. 1 to 10 and 101 to 200 and averaging times of 0.625 and 0.3125 msec., respectively, data as shown in Fig. 9 are held in the memory table in the gain controller switching controller 36.

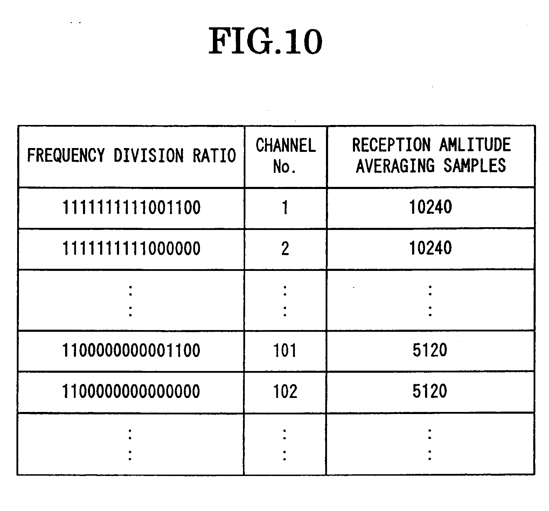

It is also possible to store the averaging time in terms of the number of data samples added together as described above. In this case, as shown in Fig. 10, the numbers of data samples added together for the reception amplitude averaging are held for individual frequency division ratios and channel Nos.

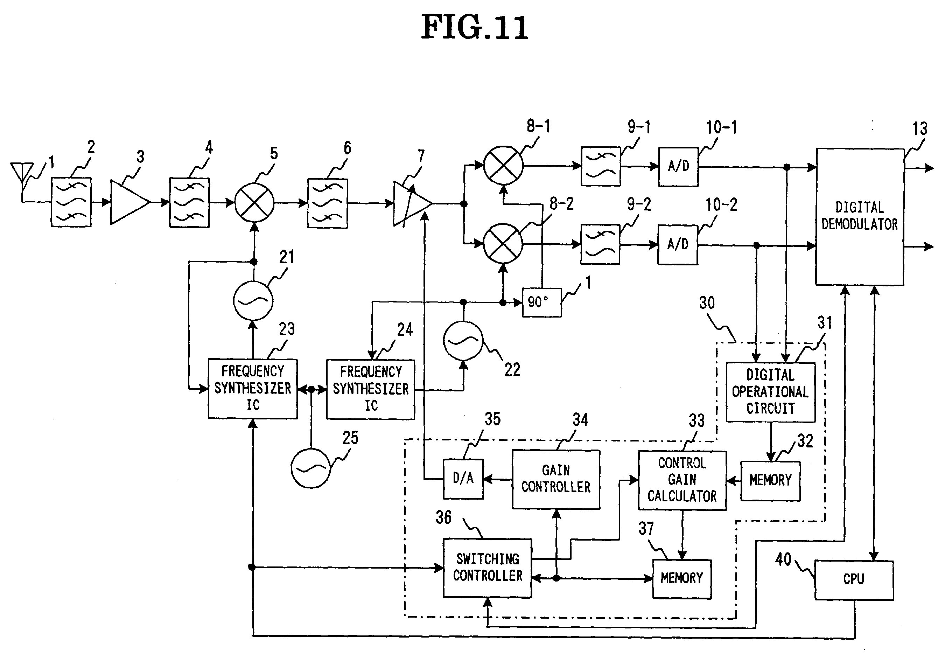

Using the table as described above, the gain controller switching controller 36 sets an appropriate in-reception amplitude averaging time for the control gain calculator 33 on the basis of a designated frequency division ratio and channel number obtained by monitoring frequency setting data input to the frequency synthesizer IC 23. Instead of using the table, it is possible, as sown in Fig. 11, the CPU 40 may directly set the time in the frequency synthesizer IC 23 and the gain controller switching controller 36. In this case, the synthesizer frequency setter 26 is unnecessary, and it is possible to further reduce the set casing size.

At the same time, the gain controller 34 reads out the time average data from the memory 37 at timings based on an appropriate (i.e., desired) gain controller switching frequency. Thus, the gain controller 33 can transfer the calculation result via the memory 37 to the gain controller 34. The appropriate, i.e., desired, gain controller switching frequency is determined on the basis of the slot length. It is possible that the gain controller switching controller 36 reads out the time average data from the memory 37.

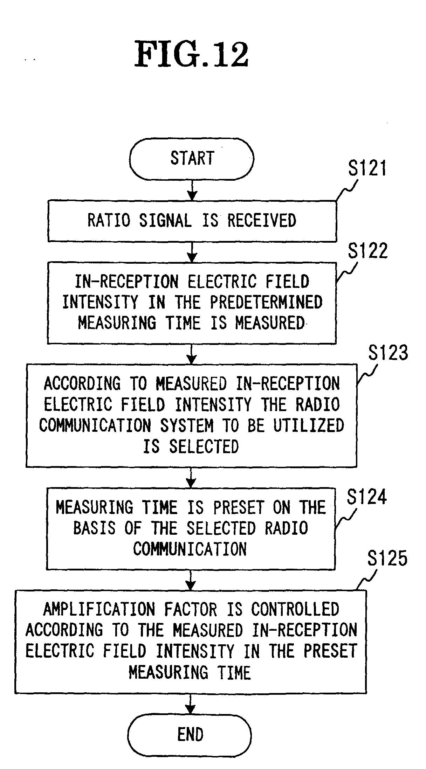

In the radio communication set as described above, the following automatic gain control method is realized. First, the in-reception electric field intensity is measured in a predetermined measuring time. The radio communication system to be utilized is selected on the basis of the measured in-reception electric field intensity. The measuring time is preset on the basis of the selected radio communication system. Then, the amplification factor is controlled on the basis of the in-reception electric field intensity measured in the preset measuring time. This automatic gain control method will be described in further detail with reference to the flow chart of Fig. 12. Referring to the Figure, radio signal is received in the radio communication set (in step S121), and the in-reception electric field intensity in the predetermined measuring time is measured (step S122).

According to the measured in-reception electric field intensity the radio communication system to be utilized is selected (step S123). The measuring time is preset on the basis of the selected radio communication system (step S124). The amplification factor is controlled on the basis of the measured in-reception electric field intensity in the preset measuring time (step S125).

In this automatic gain control, the electric intensities of signals transmitted from the base stations in the two telephone systems different in communication system from each other by interrupting the data transmission and reception. However, the interruption time may be very short. The in-reception electric field intensity measurement may be done when the line quality provided by the telephone system is deteriorated or at a predetermined frequency. The amplification factor control may be done in response to the communication channel switching.

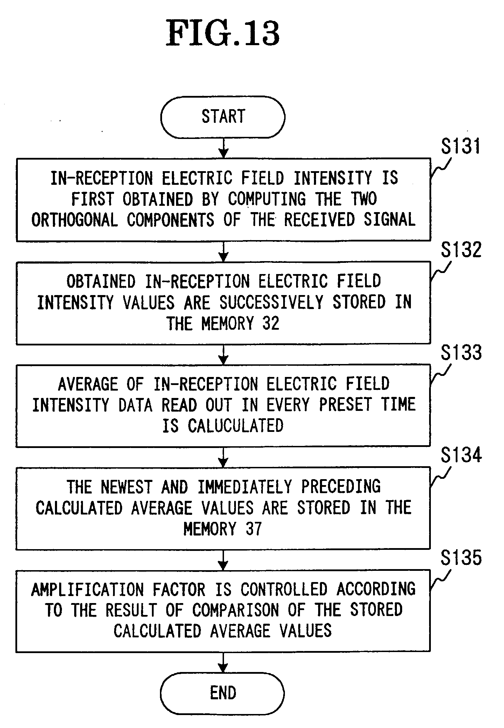

In the AGC unit 30 shown in Fig. 1, an automatic gain control method as shown in Fig. 13 is realized. Specifically, in this method the in-reception electric field intensity is first obtained by computing the two orthogonal components of the received signal (step S131). The obtained in-reception electric field intensity values are successively stored in the memory 32 (step S132). The average of in-reception electric field intensity data read out in every preset time is calculated (step S133).

Then, the newest and the immediately preceding calculated average values are stored in the memory 37 (step S134). The amplification factor is controlled on the basis of the result of comparison of the stored calculated average values (step S135).

In the above automatic gain control, it is also possible to store the calculated average values as history in the memory 37 and control the amplification factor on the basis of the average corresponding to communication channel used before among the average values stored as history. It is further possible to detect the communication channel on the basis of the frequency division ratio preset in the frequency divider, detect the communication channel on the basis of the frequency division ratio preset in the frequency divider and control the amplification factor on the basis of the read-out average.

As shown above, in the instant radio communication set stable AGC operation is done on the basis of the average in an appropriate time while communication is made by using a certain communication channel. When the communication channel in use is to be switched over to a different communication channel, data of the new communication channel may be preliminarily stored or recognized. By so doing, it is possible to immediately correct the AGC state to the optimum one.

In a radio communication system, in which survey of the in-reception electric field intensity levels of the other communication channel than that in use during communication to cause communication channel switching when an available communication channel providing a more sufficient in-reception electric field intensity level is found, the survey should be done in as short time as possible, although the necessary in-reception electric field intensity measurement accuracy is not so high. This is so because the survey of the other channels dictates tentative interruption of the communication on the prevailing communication channel, resulting in communication efficiency reduction. In such a case, by organizing a radio communication system by using the receiver on the basis of the present invention it is possible to obtain fast AGC state control with a minimum necessary accuracy.

In this case, the timing of surveying the other channels is determined as follows. For example, the in-reception electric field intensity measurement concerning the other channels is caused when the in-reception electric field intensity level of the communication channel in use becomes lower than a predetermined threshold level or when the frame error rate exceeds a predetermined threshold rate. The channel switching is caused by reading out the results of measurements (i.e., in-reception electric field intensity level data) written in the memory 32 and providing an interruption to the CPU 40 in accordance with the result of comparison of the read-out data with a predetermined threshold. In this way, the prevailing communication channel can be switched over to a different channel before line quality deterioration.

Alternatively, the in-reception electric field intensity levels may be measured upon each lapse of a predetermined time provided by a timer independently of the in-reception electric field intensity level of the communication channel in use. In this case, switching over to a better quality line than the prevailing one is obtainable. The CPU 40 determines these measurement timings. It is of course possible to adopt combined use of the above system having resort to the in-reception electric field intensity for judgment and the system using the timer.

The radio communication set is adapted to notify the period of time of in-reception electric field intensity measurement to the base station, and the base station is not allowed to change the transmission power level during that measurement time. This is so because with a transmission power level change the correct result of measurement can not be obtained.

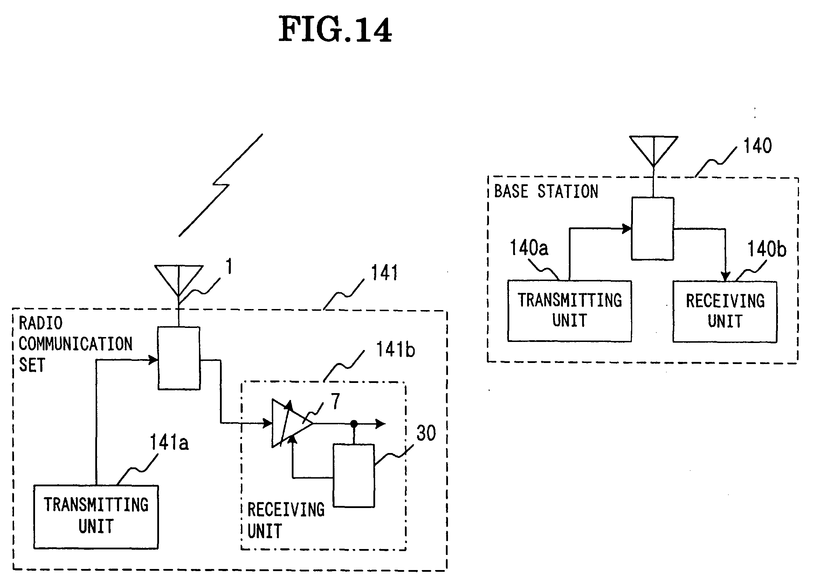

As shown in Fig. 14, a situation of data communication between a base station 140 and a radio communication set 141 will now be considered. In this case, a transmitting unit 141a in the set 141 notifies data concerning the period of time of measurement of in-reception electric field intensity in a receiving unit 141b to a receiving unit 141b in the station 140. Receiving the notification, the station 140 can know the time of measurement in the receiving unit 141b in the set 141. The transmitting unit 141a in the base station 140 executes control to hold its in-transmission power level constant during the time of measurement.

Furthermore, when the channel No. of the communication channel in use is detected, the gain controller switching controller 36 and the gain controller 34 may retrieve the communication channel use history data stored in the memory 37. This is done so for setting, at the instant of detection of the fact that the prevailing communication channel has also been used before, the gain control data at that instant in the gain controller 34. By so doing, it is possible to set most reliable initial value data and obtain quick converging of the AGC loop. The communication channel use history is constituted by channel No. of channel having been used and data concerning the time of use, etc.

As has been described in the foregoing, on the basis of the present invention when communication is being made by using a certain communication channel, stable AGC operation is executed on the basis of average data in an appropriate time. Also, when switching over to a different channel for communication, the AGC state can be immediately corrected to the optimum stage by preliminarily storing and recognizing data of the new communication channel.

Furthermore, by switching AGC data averaging time upon automatic detection of the execution of monitoring of the other channels, it is possible to readily realize the automatic switching of the AGC data averaging time without complicated control. Moreover, by using a frequency synthesizer control signal or a voltage control transmitter control signal for detecting the start of operation of monitoring the other channels, it is possible to realize appropriate AGC without substantial addition to or alteration of the prior art AGC system construction.

Changes in construction will occur to those skilled in the art and various apparently different modifications and embodiments may be made without departing from the scope of the present invention. The matter set forth in the foregoing description and accompanying drawings is offered by way of illustration only. It is therefore intended that the foregoing description be regarded as illustrative rather than limiting.

## Claims

1. A radio communication set comprising measuring means for measuring in-reception electric field intensity of signals transmitted from base stations of a first and a second telephone system different in communication system from each other, data transmission and reception being made between the radio communication set and the base station of either the first or second telephone system selected on the basis of the result of measurement in the measuring means.

2. A radio communication set comprising measuring means for measuring in-reception electric field intensity of signals transmitted from base stations of a first and a second telephone system different in communication system from each other, data transmission and reception being made between the radio communication set and the base station of either the first or second telephone system selected on the basis of the result of measurement in the measuring means, and the first telephone system being based on CDMA system, and the second telephone system being based on a system different from the CDMA system.

3. The radio communication system according to claim 2, wherein the telephone system different from the CDMA system is based on TDMA system.

4. A radio communication set comprising receiving means for receiving radio signal, measuring means for measuring in-reception electric field intensity in a predetermined measuring time, and automatic gain control means for controlling the amplification factor of the receiving means on the basis of the in-reception electric field intensity measured in the measuring means.

5. The radio communication set according to claim 4, which further comprises switching means for switching the communication channel in use on the basis of the in-reception electric field intensity measured in the measuring means, the measuring time being set on the basis of the communication channel selected by switching in the switching means.

6. A radio communication set comprising receiving means for receiving radio signal, measuring means for measuring in-reception electric field intensity in a predetermined measuring time, and automatic gain control means for controlling the amplification factor of the receiving means on the basis of the in-reception electric field intensity measured in the measuring means, the in-reception electric field intensity measured in the measuring means being an average of a plurality of in-reception electric field intensity values obtained in the measuring time.

7. The radio communication set according to claim 4, wherein at least one of a plurality of radio communication systems is selected on the basis of the in-reception electric field intensity measured in the measuring means.

8. The radio communication set according to claim 7, wherein the measuring time is set on the basis of the selected one of the plurality of radio communication systems.

9. The radio communication set according to claim 6, wherein the predetermined number is set on the basis of the selected one of the plurality of radio communication systems.

10. A radio communication set comprising receiving means for receiving radio signal, measuring means for measuring in-reception electric field intensity in a predetermined measuring time, selecting means for selecting a radio communication system to be used on the basis of the in-reception electric field intensity measured in the measuring means, setting means for setting the measuring time on the basis of the radio communication system selected in the selecting means, and automatic gain control means for controlling the amplification factor in the receiving means on the basis of the in-reception electric field intensity measured in the measuring time set in the setting means.

11. A radio communication set comprising receiving means for receiving radio signal, measuring means for measuring in-reception electric field intensity in a predetermined measuring time, selecting means for selecting a radio communication system to be used on the basis of the in-reception electric field intensity measured in the measuring means, setting means for setting the measuring time on the basis of the radio communication system selected in the selecting means, and automatic gain control means for controlling the amplification factor in the receiving means on the basis of the in-reception electric field intensity measured in the measuring time set in the setting means, the measuring means measuring the in-reception electric field intensities of signals transmitted from base stations in a first and a second telephone system different in communication system from each other.

12. A radio communication set comprising receiving means for receiving radio signal, measuring means for measuring in-reception electric field intensity in a predetermined measuring time, selecting means for selecting a radio communication system to be used on the basis of the in-reception electric field intensity measured in the measuring means, setting means for setting the measuring time on the basis of the radio communication system selected in the selecting means, and automatic gain control means for controlling the amplification factor in the receiving means on the basis of the in-reception electric field intensity measured in the measuring time set in the setting means, the measuring means measuring the in-reception electric field intensities of signals transmitted from base stations in a first and a second telephone system different in communication system from each other and measuring the in-reception electric field intensity of the signal transmitted from the base station in the second telephone system by interrupting the data transmission and reception to and from the base station in the first telephone system for a predetermined time.

13. The radio communication set according to claim 12, wherein the measuring means measures the in-reception electric field intensity of the signal transmitted from the base station of the second telephone system when the line quality provided by the first telephone system is deteriorated.

14. The radio communication set according to claim 12, wherein the measuring means measures the in-reception electric field intensity of the signal transmitted from the base station of the second telephone system at a predetermined frequency.

15. A radio communication set comprising receiving means for receiving radio signal, measuring means for measuring in-reception electric field intensity in a predetermined measuring time, selecting means for selecting a radio communication system to be used on the basis of the in-reception electric field intensity measured in the measuring means, setting means for setting the measuring time on the basis of the radio communication system selected in the selecting means, and automatic gain control means for controlling the amplification factor in the receiving means on the basis of the in-reception electric field intensity measured in the measuring time set in the setting means, the automatic gain control means controlling the amplification on the basis of the switching of communication channels.

16. A radio communication set comprising receiving means for receiving radio signal, measuring means for measuring in-reception electric field intensity in a predetermined measuring time, selecting means for selecting a radio communication system to be used on the basis of the in-reception electric field intensity measured in the measuring means, setting means for setting the measuring time on the basis of the radio communication system selected in the selecting means, automatic gain control means for controlling the amplification factor in the receiving means on the basis of the in-reception electric field intensity measured in the measuring time set in the setting means, and oscillating means with the oscillation frequency thereof controlled on the basis of the a phase difference with respect to a reference signal, phase comparing means for obtaining the phase difference between a signal obtained by frequency dividing the output of the oscillating means with a predetermined frequency division ratio and the reference signal, and frequency division ratio control means for controlling the frequency division ratio on the basis of the result of measurement in the measuring means, and the automatic gain control means controls the amplification factor on the basis of the frequency division ratio, the automatic gain control means controlling the amplification on the basis of the switching of communication channels.

17. A radio communication set comprising receiving means for receiving radio signal, measuring means for measuring in-reception electric field intensity in a predetermined measuring time, selecting means for selecting a radio communication system to be used on the basis of the in-reception electric field intensity measured in the measuring means, setting means for setting the measuring time on the basis of the radio communication system selected in the selecting means, automatic gain control means for controlling the amplification factor in the receiving means on the basis of the in-reception electric field intensity measured in the measuring time set in the setting means, and oscillating means with the oscillation frequency thereof controlled on the basis of the a phase difference with respect to a reference signal, phase comparing means for obtaining the phase difference between a signal obtained by frequency dividing the output of the oscillating means with a predetermined frequency division ratio and the reference signal, and frequency division ratio control means for controlling the frequency division ratio on the basis of the result of measurement in the measuring means, and the automatic gain control means controls the amplification factor on the basis of the frequency division ratio, the automatic gain control means controlling the amplification on the basis of the switching of communication channels and the frequency division ratio control means including means for calculating the average of the result of measurement in the predetermined time, and frequency division setting means for setting the frequency division ratio on the basis of the calculated average and a predetermined desired value.

18. The radio communication set according to claim 17, wherein the desired value is determined on the basis of the slot length.

19. A radio communication set comprising receiving means for receiving radio signal, and automatic gain control means for controlling the amplification factor in the receiving means on the basis of in-reception electric field intensity of the received signal in a predetermined time, the automatic gain control means including computing means for determining the in-reception electric field intensity by computing the two orthogonal components of the received signal, a first memory for successively storing computed in-reception electric field intensities, calculating means for calculating an average of in-reception electric field intensity data read out from the first memory in every predetermined time, a second memory for storing at least the newest and the immediately preceding values of average calculated in the calculating means, and gain control means for controlling the amplification factor on the basis of the result of comparison of calculated values stored in the second memory.

20. The radio communication set according to claim 19, wherein the second memory stores average values calculated in the calculating means as history, and the gain control means controls the amplification factor on the basis of the average value corresponding to a communication channel used before among the average values stored as history in the second memory.

21. The radio communication set according to claim 19, which further comprises control means for detecting the communication channel on the basis of a frequency division ratio preset in a frequency divider in the receiving means and reading out the average value corresponding to the detected communication channel from the second memory.

22. A radio communication system comprising a radio communication set on the basis of one of claims 1 to 21, and a base station for transmitting and receiving data to and from the radio communication set, wherein the radio communication set includes means for notifying the measuring time of measurement in the measuring means to the base station, the base station holding a fixed communication level in the measuring time.

23. An automatic gain control method for a radio communication set comprising a receiving step of receiving radio signal, a measuring step of measuring in-reception electric field intensity in a predetermined measuring time, a selecting step of selecting a radio communication channel to be used on the basis of the in-reception electric field intensity measured in a predetermined measuring time, a setting step of setting the measuring time on the basis of the radio communication step selected in the selecting step, and an automatic gain control step of controlling the amplification factor in the receiving step on the basis of the in-reception electric field intensity measured in the measuring time set in the setting step.

24. The automatic gain control method according to claim 23, wherein in the measuring step in-reception electric field intensities of signal transmitted from base stations in a first and a second telephone system different in communication system from each other are measured.

25. The automatic gain control method according to claim 23, wherein in the measuring step the in-reception electric field intensity of the signal transmitted from the base station in the second telephone system is measured by interrupting data transmission and reception to and from the base station in the first telephone system for a predetermined time.

26. The automatic gain control method according to claim 23, wherein in the measuring step the in-reception electric field intensity of the signal transmitted from the base station of the second telephone system is measured when the line quality provided by the first telephone system is deteriorated.

27. The automatic gain control method according to claim 23, wherein in the measuring step the in-reception electric field intensity of the signal transmitted from the base station in the second telephone system is measured at a predetermined frequency.

28. The automatic gain control method according to claim 23, wherein in the automatic gain control step the amplification is controlled in response to communication channel switching.

29. An automatic gain control method for a radio communication set, which comprises receiving means for receiving radio signal, and automatic gain control means for controlling the amplification factor in the receiving means on the basis of the in-reception electric field intensity of the received signal in a predetermined time, the method comprising a step of determining the in-reception electric field intensity by computing two orthogonal components of the received signal, a step of successively storing computed in-reception electric field intensities in a first memory, a step of calculating the average of stored in-reception electric field intensities read out very predetermined time, a step of storing the newest and the immediately preceding calculated average values, and a step of controlling the amplification factor on the basis of the result of comparison of stored average values.

30. The automatic gain control method according to claim 29, wherein the calculated average values are stored as history in the second memory, and the amplification factor is controlled on the basis of the average corresponding to a communication channel used before among the average values stored as history.

31. The automatic gain control method according to claim 29, which further comprises a step of detecting the communication channel on the basis of a frequency division ratio preset in a frequency divider in the receiving means and reading out the average value corresponding to the detected communication channel from the second memory, the amplification being controlled on the basis of the read-out average value.
